## Europäisches Patentamt

## European Patent Office

## Office européen des brevets

(19)

(11) Numéro de publication: **0 142 891**
**B1**

(12) **FASCICULE DE BREVET EUROPEEN**

(45) Date de publication du fascicule du brevet:
28.10.87

(51) Int. Cl.⁴: **H 01 L 27/14**, H 01 L 29/80

(21) Numéro de dépôt: **84201630.5**

(22) Date de dépôt: **12.11.84**

(54) **Dispositif à couplage de charges sensible au rayonnement infrarouge et procédé de réalisation d'un tel dispositif.**

(30) Priorité: **14.11.83 FR 8318028**

(43) Date de publication de la demande:
**29.05.85 Bulletin 85/22**

(45) Mention de la délivrance du brevet:
**28.10.87 Bulletin 87/44**

(84) Etats contractants désignés:
**DE FR GB NL**

(56) Documents cités:
**US - A - 4 257 057**
**US - A - 4 285 000**

**APPLIED PHYSICS LETTERS, vol. 36, no. 6, mars 1980, pages 458-461, American Institute of Physics, New York, US; Y.Z. LIU et al.: "Observation of charge storage and charge transfer in a GaAlAsSb/GaSb charge-coupled device"**
**1980 INTERNATIONAL ELECTRON DEVICES MEETING, décembre 1980, pages 338-341, IEEE, Washington D.C., US; Y.Z. LIU et al.: "Low dark current glass bonded AlGaAs/GaAs schottky gate imaging CCD"**
**JOURNAL OF THE ELECTROCHEMICAL SOCIETY, vol. 125, no. 1, janvier 1978, pages 123-127, Princeton, US; K. NAKAJIMA et al.: "Phase diagram of the In-Ga-As-P quaternary system and LPE growth conditions for**

(56) Entgegenhaltungen: (Fortsetzung)
**lattice matching on InP substrates"**
**IEEE JOURNAL OF QUANTUM ELECTRONICS, vol. QE-17, no. 2, février 1981, pages 239-242, IEEE, New York, US; K. TAKAHASHI et al.: "A monolithic 1 x 10 array of InGaAsP/InP photodiodes with small dark current and uniform responsivities"**

(73) Titulaire: **Laboratoires d'Electronique et de Physique Appliquée L.E.P., 3, Avenue Descartes, F-94450 Limeil-Brévannes (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **DE GB NL**

(72) Inventeur: **Jarry, Philippe, Société Civile S.P.I.D. 209 rue de l'Université, F-75007 Paris (FR)**

(74) Mandataire: **Landousy, Christian et al, Société Civile S.P.I.D. 209, Rue de l'Université, F-75007 Paris (FR)**

## Description

L'invention concerne un dispositif à couplage de charges (CCD) sensible au rayonnement infrarouge dans un domaine compris entre les longueurs d'onde $\lambda_0$ et $\lambda_1$, composé d'une succession de trois couches en matériau semiconducteur du groupe III–V de la classification de Mendeleev, de paramètres de maille cristalline extrêmement voisins, la première couche dite fenêtre présentant une large bande d'énergie interdite donc une faible longueur d'onde d'absorption limite $\lambda_0$, la seconde couche dite absorbante, présentant une moins large bande d'énergie interdite donc une plus grande longueur d'onde d'absorption limite $\lambda_1$, et la troisième couche, dite de stockage, présentant une large bande d'énergie interdite donc une faible longueur d'onde d'absorption limite, et supportant au moins une électrode de type contact ohmique constituant la sortie 0 du dispositif et une pluralité d'électrodes de commande disposées régulièrement à la surface de cette couche de manière à former une ligne ou une matrice d'éléments photosensibles, isolées les unes des autres et polarisées séquentiellement par les signaux d'une ou plusieurs horloges $H_1$, $H_2$... $H_n$.

L'invention concerne en outre un procédé de réalisation permettant d'obtenir ce dispositif.

Un tel CCD est connu par la publication de Y.Z. Liu, et alii, dans la revue «Applied Physics Letters, 36 (6), 15 mars 1980», p. 458–461, intitulée «Observation of Charge storage and charge transfer in a GaAlAsSb/GaSb charge-coupled device».

Ce document décrit un dispositif sensible au rayonnement infrarouge dans le domaine compris entre 1,0 μm et 1,8 μm. Un tel dispositif présente un intérêt pour des applications militaires terrestres (par exemple, pour la réaliastion de dispositifs d'imagerie infrarouge) et pour des applications sous-marine.

Il existe en effet, dans le domaine des longueurs d'onde comprises en 0,9 et 2 μm, un rayonnement ambiant très supérieur à celui qui existe dans le domaine des longueurs d'onde inférieures à 0,9 μm, car à partir de 1 μm environ, la contribution des photons due au rayonnement thermique propre à un objet à détecter, est très importante. Ce phénomène permet, si l'on dispose de détecteurs sensibles dans cette zone, d'espérer de très bons résultats.

Ladite publication décrit un dispositif constitué d'une couche fenêtre en GaAlAsSb, composé quaternaire à large bande d'énergie interdite, donc faible longueur d'onde d'absorption limite de l'ordre de 1 μm, d'une couche absorbante en GaSb, composé binaire à bande d'énergie étroite donc grande longueur d'onde d'absorbtion limite de l'ordre de 1,8 μm, et d'une couche de stockage en GaAlAsSb, composé quaternaire à large bande d'énergie interdite, donc faible longueur d'onde d'absorption limite. Les électrodes de commande sont à barrière Schottky.

Un procédé de réalisation connu (voir 1980 International Electron Devices Meeting, décembre 1980, IEEE, Washington D.C., p. 338–341) permettant d'obtenir ce dispositif à couplage de charge consiste à partir l'un substrat en antimoniure de gallium (GaSb) sur lequel, on fait croître, par épitaxie en phase liquide, la première couche, puis la seconde et la troisième couche. Cet ensemble peut être scellé sur une lame en verre servant de support mécanique, de protection pour la couche fenêtre et de filtre pour les faibles longueurs d'onde. Puis le substrat d'origine en GaSb peut être éliminé par voie chimique, et les différentes électrodes peuvent être réalisées par des procédés classiques.

Cependant ce procédé de réalisation présente plusieurs inconvénients. Tout d'abord, le substrat de départ en GaSb est très difficile à réaliser. Les lingots obtenus par la technologie actuellement connue contiennent de nombreuses dislocations. Il est évident que les couches épitaxiales réalisées à partir d'un tel substrat contiennent également un taux élevé de dislocations.

De plus, les lingots de GaSb obtenus sont d'un très petit diamètre. Ils ne permettent pas la réalisation d'un grand nombre de CCD à la fois sur la même plaquette, ou même la réalisation de CCD de grande surface. Ceci est un inconvénient considérable sur le plan de l'avenir industriel à court terme du procédé.

D'autre part le domaine de démixion du composé étant très important, la couche quaternaire de (Ga, Al) (As, Sb) est extrêmement difficile à élaborer.

En outre, l'utilisation d'une couche de type quaternaire comme couche de stockage rend la technologie de réalisation des diverses électrodes très difficile. De ce fait, il découle en particulier, que ce procédé n'offre aucune autre possibilité, en ce qui concerne les électrodes de commande, que de réaliser des barrières Schottky. D'autre part les contacts ohmiques sont également difficiles à réaliser. Enfin, il est nécessaire de réaliser un contact ohmique supplémentaire pour l'anneau de garde, qui est une porte polarisée de manière à déserter la couche n de stockage, entre les électrodes de commande.

Enfin ce dispositif doit être refroidi à 77°K de manière à réduire le courant d'obscurité.

Cependant l'inconvénient le plus grave réside dans le fait qu'il n'existe aucune synergie entre la fabrication d'un tel CCD et la fabrication des circuits intégrés. Ceci est certes un problème sur le plan du développement industriel de cette nouvelle technologie, car il est très coûteux de mettre en œuvre une technologie difficile, pour réaliser seulement un petit nombre de dispositifs. Mais ceci est un plus grand problème pour la réalisation du CCD lui-même. En effet, il est indispensable d'adjoindre au CCD un certain nombre de circuits périphériques, tel qu'un amplificateur de sortie, un circuit de génération de signaux d'horloge, qui sont des circuits intégrés ultrarapides ou hyperfréquences. Il est souhaitable de pouvoir intégrer ces circuits monolithiquement sur le même substrat que le CCD de manière à augmenter la vitesse et la fiabilité de l'ensemble, tout en diminuant son coût de fabrication et les difficultés technologiques de réalisation. Ceci se révèle impossible à l'aide de la technologie décrite dans le document cité.

La présente invention permet de pallier ces inconvénients en présentant un nouveau dispositif à couplage de charges (CCD), tel que défini dans le préambule, remarquable en ce que premièrement la couche fenêtre et la couche de stockage sont constituées d'un composé binaire AB, A étant un élément du groupe III et B un élément du groupe V, ce composé binaire étant choisi comme présentant une large bande d'énergie interdite et la faible longueur d'onde d'absorbtion limite $\lambda_0$ voulue, en ce que deuxièmement la couche absorbante est constituée d'un composé n-aire $(A, X, Y...)_{III} (B, M, N...)_V$, n supérieur ou égal à 3, comportant toujours les éléments A et B, où les éléments A, X, Y, du groupe III et leur concentration d'une part, et où les éléments B, M, N... du groupe V et leur concentration d'autre part, sont choisis de manière à adapter le paramètre de maille cristalline du composé n-aire à celui du composé binaire, tout en déterminant pour ce composé n-aire la bande d'énergie interdite étroite donc la grande longueur d'onde d'absorption limite $\lambda_1$ voulue, ce composé n'appartenant pas au domaine de démixion de la solution solide n-aire et présentant en outre une transition de bande interdite directe.

Un avantage présenté par un tel dispositif réside dans le fait que la couche active est une couche binaire compatible avec les circuits intégrés $A_{III} B_V$.

Selon une variante de ce dispositif, la couche absorbante est constituée d'un composé quaternaire $C_x A_{1-x} D_y B_{1-x}$ où C est un élément du groupe III et D un élément du groupe V.

Selon une réalisation préférentielle, ce dispositif est remarquable en ce que premièrement les couches binaires sont du composé InP de longueur d'onde d'absorption limite $\lambda_0 \simeq 0,9$ µm, et en ce que deuxièmement la couche quaternaire est du composé $Ga_x In_{1-x} As_y P_{1-y}$ où x = 0,47 et y ≥ 0,9, de longueur d'onde d'absorption limite $\lambda_1 \simeq 1,7$ µm.

Un avantage présenté par ce dernier CCD réside dans le fait qu'il est particulièrement bien adapté aux applications envisagées de dispositifs d'imagerie infra-rouge.

Un procédé de réalisation d'un dispositif conforme à l'invention comporte les étapes suivantes: premièrement un substrat monocristallin est réalisé à partir d'un lingot du composé binaire semiconducteur AB, deuxièmement, sur ce substrat, sont réalisées successivement, par croissance épitaxiale, les couches suivantes:

a) une couche d'arrêt chimique du composé n-aire $(A, X, Y...)_{III} (B, M, N...)_V$,

b) la couche de stockage du composé binaire AB dopée n,

c) la couche absorbante du composé n-aire dopée p,

d) la couche fenêtre du composé binaire AB, troisièmement, l'ensemble ainsi constitué est scellé par la face externe de la couche fenêtre à la lame support, quatrièmement le substrat et la couche d'arrêt chimique sont éliminés successivement par des attaques chimiques sélectives, et cinquièmement les contacts d'électrodes sont réalisés à la surface de la couche de stockage.

La description suivante, illustrée par les figures ci-après annexées, fera mieux comprende comment l'invention est réalisée.

La fig. 1 représente, en coupe schématique, un CCD selon la présente invention;

la fig. 2 représente, en coupe schématique, les différentes étapes du procédé de réalisation d'un CCD selon la présente invention.

Les figures sont représentées schématiquement à échelle, mais pour la clarté du dessin, les dimensions, notamment dans la direction de l'épaisseur de la section transversale, sont fortement exagérées.

Enfin les zones semiconductrices de même type sont hachurées de la même façon, et dans les différentes figures les parties correspondantes sont désignées par les mêmes chiffres de référence.

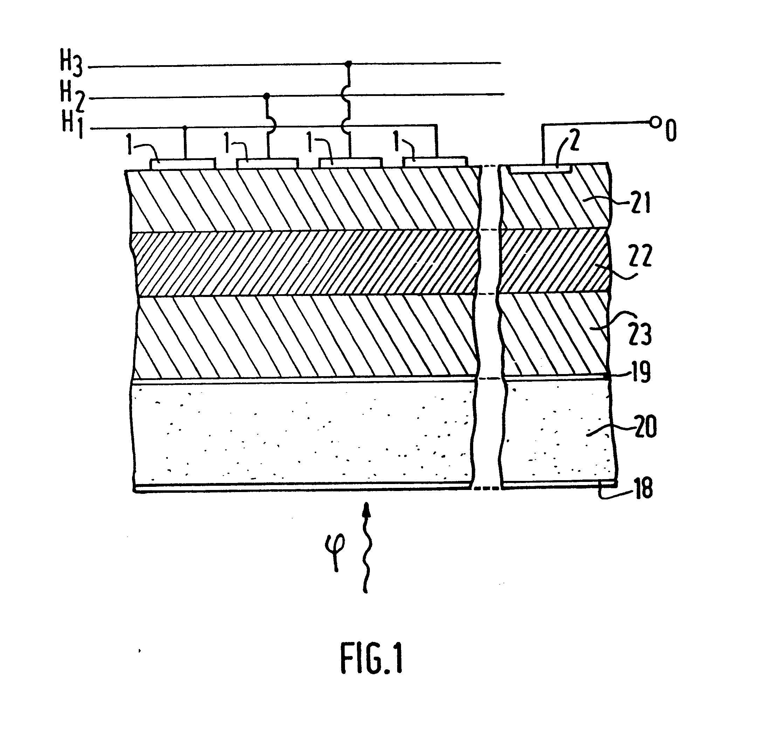

Tel que représenté sur la fig. 1, le CCD sensible au rayonnement infrarouge réalisé selon la présente invention comprend d'abord une lame support 20, de part et d'autre de laquelle se trouvent des couches anti-reflet 18 et 19.

Cette lame support soutient les trois couches de matériaux semiconducteurs différents constituant le CCD proprement dit. La première couche est la couche fenêtre 23. Elle est constituée d'un composé binaire AB où A est élément du groupe III et B un élément du groupe V de la classification de Mendeleev. Ce composé est choisi parmi les semiconducteurs du groupe III–V qui présentent une large bande d'énergie interdite donc une faible longueur d'onde d'absorption limite $\lambda_0$. Cette couche absorbe les rayonnements de faible longueur d'onde, ce qui permet d'améliorer le contraste, et elle réduit la recombinaison à la surface de la couche suivante.

La seconde couche est la couche absorbante 22, dopée p. Elle est réalisée en un matériau quaternaire $C_x A_{1-x} D_y B_{1-y}$ où C et D sont des éléments du groupe III et du groupe V respectivement. Elle présente une bande d'énergie interdite étroite, un grand coefficient d'absorption, une longueur de diffusion courte, de manière à obtenir une haute résolution spatiale et une efficacité quantique élevée. Cette couche absorbe la totalité des photons dans le domaine délimité et par sa propre longueur d'onde d'absorption limite, et génère les paires électrons-trous, dont les électrons diffusent dans la troisième couche ou couche de stockage.

Or, de l'ouvrage intitulé «Hétérostructure lasers» de H.C. Casey et H.B. Panish, publié par Académic Press (1978), il est connu qu'il existe entre l'énergie de bande interdite $E_G$ d'un tel composé et les concentrations x et y une relation de la forme:

$$E_G = f(x, y)$$

et qu'il existe d'autre part, entre le paramètre de maille cristalline a et ces concentrations une relation de la forme:

$$a = g(x, y)$$

Les éléments C et D étant choisis de manière à constituer avec A et B un composé présentant une faible zone de démixion, et une transition de bande interdite directe, le paramètre de maille cristalline a de ce composé est alors choisi de manière à être adapté au paramètre de maille du composé binaire AB, tandis que son énergie de bande interdite $E_G$ est choisie de manière à être faible, correspondant à une grande longueur d'onde d'absorption limite $\lambda_1$.

La résolution des deux équations citées plus haut permet, à partir des valeurs de a et $E_G$ choisies indépendamment l'une de l'autre, de déterminer la valeur des concentrations x et y, donc la composition du matériau quaternaire $C_xA_{1-x}D_yB_{1-y}$, tout en prenant soin que ce composé ainsi déterminé n'appartienne pas au domaine de démixion de la solution solide.

On notera d'une part que la relation:

$$E_G = \frac{h \cdot c}{\lambda}$$

où

h = 6,6252,10⁻³⁴J.s. → h = $6{,}6252{,}10^{-34}$ J.s.
c = $2{,}9979.10^{8}$ m.s.$^{-1}$
$\lambda$ = la longueur d'onde d'absorption,

permet de calculer $E_G$ en fonction de $\lambda$ et donc de choisir le domaine de sensibilité d'un CCD pour des éléments A, B, C et D donnés.

On notera, d'autre part, que le composé $C_xA_{1-x}D_yB_{1-y}$ est en réalité un pseudobinaire du fait que les atomes des éléments C et D viennent occuper des sites des atomes A et B respectivement. Dans ces conditions, on peut concevoir des CCD présentant un domaine de sensibilité différent, et en particulier une longueur d'onde d'absorption limite $\lambda_1$ plus grande, en introduisant dans le composé constituant la couche sensible 22, des éléments des groupes III et V, supplémentaires de manière à former un composé n-aire du type:

$$(A, X, Y...)_{III} (B, M, N...)_V$$

tout en conservant l'accord de maille entre ce nouveau composé et le composé binaire AB.

La troisième couche du CCD est la couche de stockage 21. Elle présente une structure binaire AB. Cette dernière couche, de type n, présente une bande d'énergie interdite aussi large que possible de manière à obtenir un dispositif à faible courant d'obscurité, faible courant de fuite, et faible courant dans le canal. Elle doit présenter en outre une mobilité électronique élevée, car cette propriété influe sur l'efficacité de transfert du dispositif. Enfin cette couche supporte les électrodes de commande 1, destinées à recevoir un ou plusieurs signaux d'horloge $H_1$, $H_2$...$H_n$, ainsi que la ou les électrodes de sortie 2 destinées à recueillir le ou les signaux de sortie 0.

Ainsi, une injection de photons due à l'éclairement de la couche fenêtre par la face arrière de la lame support transparente à l'aide d'un rayonnement $\varphi$ de longueur d'onde comprise entre $\lambda_0$ et $\lambda_1$, crée donc dans la couche absorbante des paires électrons-trous en quantité proportionnelle à l'énergie lumineuse absorbée. La couche de stockage de type n étant munie d'un réseau d'électrodes de commande disposées sous forme de matrice, l'application d'une tension sur ces électrodes entraîne la formation, sous ces dernières, de puits de potentiel dépeuplés. Les photoélectrons générés sont collectés dans les puits de potentiel destinés à la détection, où ils sont accumulés pendant une période trame, puis transférés par un registre à décalage jusqu'à un dispositif de sortie, généralement constitué d'un amplificateur de lecture.

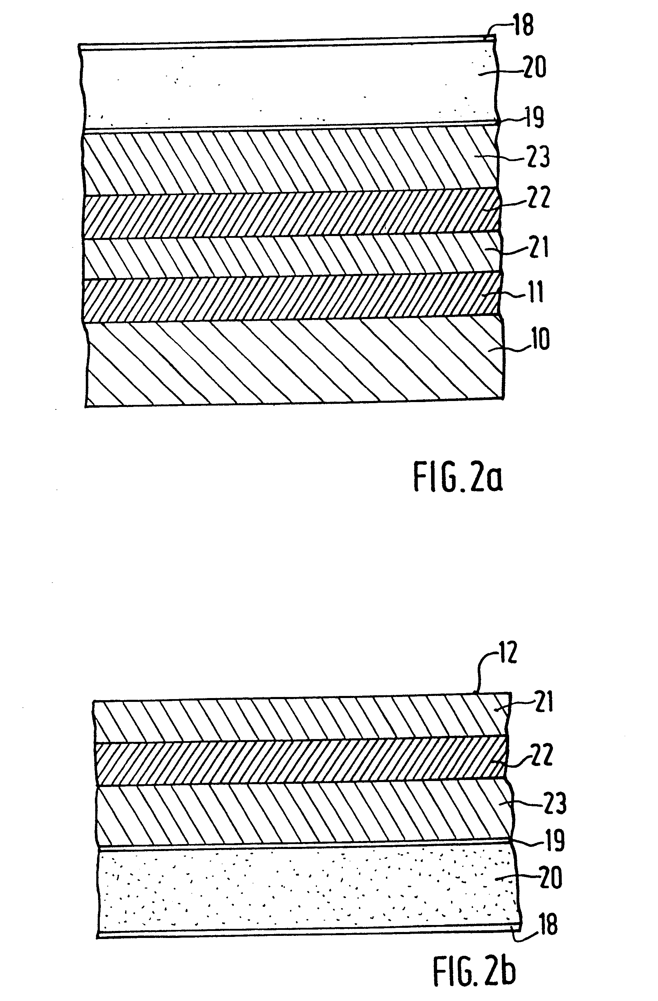

Les fig. 2a et 2b illustrent les différentes étapes du procédé de réalisation d'un CCD selon la présente invention. Un lingot du composé binaire AB fournit un substrat 10, qui impose son paramètre de maille cristalline à toutes les couches épitaxiales réalisées ultérieurement. Sur ce substrat 10, est alors réalisée une couche épitaxiale 11 du matériau n-aire choisi, ou couche d'arrêt chimique. La fonction de cette dernière est de constituer un support présentant le paramètre de maille cristalline requis pour la croissance ultérieure de la couche binaire 21 de composition AB, tout en possédant la propriété de permettre la dissolution chimique du substrat 10 sans être elle-même attaquée, puis, de pouvoir être dissoute chimiquement sans que soit altérée la couche suivante 21.

Sur la couche 11 sont donc réalisées successivement par croissance épitaxiale, la couche binaire 21 du matériau AB dopé n, la couche 22 du matériau n-aire, dopé p, et la couche binaire 23 du matériau AB.

De manière à améliorer la transmission optique, il peut être alors réalisé, à la surface de la couche 23, une série de couches antireflet 19.

La fonction d'une telle série de couches est de couper les rayonnements de longueur d'onde inférieur à $\lambda_0$ et supérieur à $\lambda_1$ et de laisser passer avec une transmission aussi grande que possible (réflexion sur les faces minimale) les rayonnements de longueur d'onde compris entre $\lambda_0$ et $\lambda_1$. Dans ce but, la série est composée d'un nombre impair, le plus grand possible (au moins 9) de couches d'épaisseur $\lambda/4$ pour la longueur d'onde moyenne de l'intervalle $\lambda_0$, $\lambda_1$. Ces couches sont constituées de matériaux transparents dans le domaine de longueur d'onde $\lambda_0$, $\lambda_1$, alternativement de fort et de faible indice de réfraction, la série de couches commençant et finissant par une couche d'indice fort. Les couches extrêmes doivent être en outre adaptées aux milieux avec lesquels elles sont en contact (air, ou matériau semi-isolant) et peuvent pour cette raison être prévues d'épaisseur légèrement différente de $\lambda/4$ ou même d'épaisseur très différente, pouvant aller jusqu'à $\lambda/2$.

L'ensemble constitué par le substrat 10 et les couches 11, 21, 22 et 23, est alors scellé sur la lame support 20 qui peut être, selon l'application, en verre ou en résine polymérisable. Puis le substrat 10, d'une part, et la couche d'arrêt chimique 11, d'autre part, sont éliminés successivement par des attaques chimiques sélectives, sans porter atteinte aux trois couches 21, 22 et 23, qui constituent le CCD proprement dit, comme il est montré sur la fig. 2b. On met ainsi à nu la surface 12 de la couche de stockage 21, sur laquelle seront réalisées les électrodes du dispositif.

A ce stade, peut être réalisée, sur la face externe de la lame support 20, une série de couches antireflet 18, selon le même principe que la série de couches 19.

En ce qui concerne les électrodes de commandes 1, sur des couches binaires AB, telle que la couche 21 décrite, elles peuvent être aussi bien des barrières Schottky que des contacts de type MIS.

Les électrodes de type Schottky ont l'avantage d'être «anti-éblouissement», c'est-à-dire d'améliorer la définition optique du dispositif en fonctionnement. Alors que les contacts MIS (Métal-Isolant-Semiconducteur) sont beaucoup plus faciles à réaliser sur le plan technologique.

Sur la surface 12 de la couche 21, est enfin réalisée l'électrode de sortie 2, sous la forme d'un contact ohmique.

Les électrodes de commande 1 sont disposées à la surface de la couche 21 sous forme d'une matrice groupant un certain nombre de lignes terminées chacune par une sortie 0 référencée 2. Chacune de ces lignes doit être isolée des autres.

Selon la présente invention cet isolement sera fait de préférence par bombardement de protons. Mais il pourrait être fait également, comme il est décrit dans le premier document cité à titre d'art antérieur, par un anneau de garde réalisé sous la forme d'un contact ohmique, ou bien par gravure de la couche 21. Cependant une couche binaire telle que choisie pour réaliser le CCD selon l'invention permet d'avoir recours au bombardement de protons qui est la forme d'isolement la plus simple.

Dans le procédé de réalisation du CCD selon l'invention, l'épaisseur de la couche absorbante 22 est choisie en fonction de la longueur de diffusion dans le matériau n-aire, alors que l'épaisseur de la couche de stockage 21 est choisie en fonction de l'épaisseur du canal souhaité pour la valeur de la polarisation utilisée.

Une mise en œuvre préférentielle de ce procédé de réalisation permet d'obtenir un CCD particulièrement bien adapté au fonctionnement dans le domaine des longueurs d'onde compris entre 0,9 et 1,7 μm, donc convenant plus spécialement à l'application envisagée dans le préambule.

A cet effet, un lingot de phosphure d'indium InP fournit le substrat binaire 10 de départ, sur lequel sont réalisées successivement par croissance épitaxiale, la couche 11 du semiconducteur quaternaire $Ga_xIn_{1-x}As_yP_{1-y}$, la couche 21 d'InP dopé n, la couche 22 de $Ga_xIn_{1-x}As_yP_{1-y}$ dopée p, et enfin la couche 23 d'InP.

Le composé binaire d'InP présente un paramètre de maille cristalline $a_0 \simeq 0,587$ nm et une énergie de bande interdite $E_{Go} \simeq 1,35$ eV à la température de 300°K, correspondant à la longueur d'onde d'absorption limite $\lambda_0 \simeq 0,9$ μm.

L'ouvrage intitulé «Hétérostructures lasers» déjà cité, enseigne que la composé $Ga_xIn_{1-x}As_yP_{1-y}$ présente (page 38 de ce document) une énergie de bande interdite $E_{G1}$ qui varie de 0,74 à 1,35 eV (la longueur d'onde d'absorption limite $\lambda_1$ de ce composé variant alors de 1,7 à 0,9 μm) à 300°K. D'après la figure 5.5.6 de ce document (page 40) l'accord de maille entre InP et $Ga_xIn_{1-x}As_yP_{1-y}$ peut être obtenu pour $E_G \simeq 0,74$ eV ($\lambda_1 \simeq 1,7$ μm) si $x \simeq 0,47$, la valeur de $E_G$ étant donnée par la relation $E_G \simeq 1,35 - 1,3 x$.

La concentration y étant liée à la concentration x, dans ce composé, par la relation $y \simeq 2 x$, connue d'après la publication de QUILLEC et alii dans APL 42 (10) du 15 mai 1983, l'accord de maille est alors obtenu entre les deux couches considérées si:

$$y \geq 0,9$$

Dans ce procédé de réalisation préférentiel, il a été adopté une épaisseur $e_1 = 0,3$ à 2 μm pour la couche 21 de stockage

$e_2 = 2$ à 10 μm pour la couche 2 absorbante
$e_3 = 5$ à 10 μm pour la couche 23 fenêtre.

L'élimination du substrat 10 et de la couche d'arrêt chimique 11 peut être faite respectivement à l'aide d'un mélange constitué d'une partie d'acide $H_3PO_4$ concentré à 80% et d'une partie d'acide HCl concentré à 40%, ce mélange étant porté à 50 °C, puis à l'aide d'un mélange constitué d'une partie d'acide HF concentré à 50% d'une partie d'acide $HNO_3$ concentré à 30% et d'une partie d'eau.

Les contacts ohmiques constituant la sortie 2 sont réalisés les premiers sur la surface 12 de la couche 21. Des ouvertures pratiquées dans une laque photosensible (photoresist) définissent la position de ces contacts. Dans ces ouvertures est déposé par exemple un eutectique or-germanium (Ge-Au dans les proportions 88–12), qui est porté à 450 °C pour former l'alliage. Une couche de nickel (Ni) est ensuite déposée à la surface des contacts.

Cette première couche de laque photosensible, constituant le premier masque est éliminée, et un second masque analogue est déposé sur la surface 12 de manière à définir la position des électrodes de commande.

Dans la mise en œuvre du procédé selon l'invention deux types d'électrodes de commande peuvent donc être réalisés, selon le but recherché.

Les électrodes du type barrière Schottky peuvent être réalisées par dépôts successifs dans les ouvertures du second masque, d'une couche de titane (Ti) d'environ 100 nm d'épaisseur, d'une couche d'aluminium (Al) d'environ 500 nm et d'une couche de platine (Pt) destinée à éviter l'oxydation de l'aluminium.

Dans une variante de ce procédé, des contacts de type MIS peuvent être réalisés par dépôts successifs dans les ouvertures du second masque, d'une couche d'isolant tel que $SiO_2$ ou $Si_3N_4$, d'une couche d'aluminium (Al) et d'une couche de platine (Pt).

Le second masque est alors également éliminé.

On procède ensuite à l'isolement des rangées d'électrodes de commande, de façon préférentielle par bombardement de protons.

En ce qui concerne les couches anti-reflet que l'on peut être amené à réaliser au cours d'un tel procédé, elles seront constituées de nitrure de silicium $Si_3N_4$ pour les couches d'indice de réfraction élevé, l'indice de ce corps étant $n_1 \simeq 2$, et de silice $SiO_2$ pour les couches d'indice faible, l'indice de ce dernier corps étant $n_2 \simeq 1,5$.

Avec 13 de ces couches alternées, d'épaisseur environ $\lambda/4$ pour les couches extrêmes, et d'épaisseur égale à $\lambda/4$ pour les couches centrales, une transmission de 99,99% peut être obtenue avec $\lambda \simeq 1,1$ μm dans le domaine de longueur d'onde compris entre $\lambda_0 = 0,9$ μm et $\lambda_1 = 1,7$ μm.

La température préférentielle de fonctionnement du dispositif obtenu à l'aide de ce dernier procédé est de l'ordre de 77°K. Cependant une température de 210°K obtenue par refroidissement à l'aide d'élément «Peltier» est acceptable pour obtenir un contraste suffisant, un tel système de refroidissement permettant la réalisation d'un dispositif d'imagerie simple et facilement transportable.

D'une façon générale, les CCD réalisés sont la présente invention, ayant pour couche de stockage une couche binaire sont en synergie de fabrication avec des circuits intégrés ultrarapides ou hyperfréquences.

Mais il est remarquable que, dans le cas précis où le CCD est réalisé à partir du composé binaire InP, non seulement il est possible de réaliser des circuits à haute performance monolithiquement intégrés avec le CCD, mais encore ce dernier possède un avenir particulièrement intéressant du fait que son domaine de sensibilité est spécialement bien adapté à la réalisation de dispositifs d'imagerie infrarouge tels que définis dans le préambule.

Il faut noter en outre tous les avantages offerts par le procédé permettant d'aboutir à un tel CCD.

Tout d'abord le lingot de départ en InP peut être réalisé de grand diamètre et de bonne qualité cristalline, ce qui permet d'obtenir de bonnes couches épitaxiales. Ensuite la couche quaternaire (Ga, In) (As, P) montre une faible zone de démixion et peut être obtenue facilement. Enfin, il est loisible de choisir entre des électrodes de type MIS ou à barrière Schottky, ainsi que de réaliser l'isolement de ces électrodes par une méthode simple.

Il est manifeste que d'une part de nombreuses variantes à ce dispositif, ainsi que des applications différentes de ce procédé, sont possibles, sans pour autant sortir du cadre de la présente invention, tel que défini par les revendications ci-après annexées.

## Revendications

1. Dispositif à couplage de charges (CCD) sensible au rayonnement infrarouge dans un domaine compris entre les longueurs d'onde $\lambda_0$ et $\lambda_1$, composé d'une succession de trois couches en matériau semiconducteur de groupe III–V de la classification de Mendeleev, de paramètres de maille cristalline extrêmement voisins, la première couche (23) dite fenêtre présentant une large bande d'énergie interdite donc une faible longueur d'onde d'absorption limite $\lambda_0$, la seconde couche (22) de type p, dite absorbante, présentant une moins large bande d'énergie interdite donc une plus grande longueur d'onde d'absorption limite $\lambda_1$, et la troisième couche (21), de type n, dite de stockage, présentant une large bande d'énergie interdite donc une faible longueur d'onde d'absorbtion limite, et supportant au moins une électrode (2) de type contact ohmique constituant la sortie (0) du dispositif et une pluralité d'électrodes de commande (1) disposées régulièrement à la surface de cette couche de manière à former une ligne ou une matrice d'éléments photosensibles, isolées les unes des autres et polarisées séquentiellement par les signaux d'une plusieurs horloges ($H_1$, $H_2$... $H_n$), ce dispositif étant caractérisé en ce que premièrement la couche fenêtre (23) et la couche de stockage (21) sont constituées d'une composé binaire AB, A étant un élément du groupe III et B un élément du groupe V, ce composé binaire étant choisi comme présentant une large bande d'énergie interdite et la faible longueur d'onde d'absorption limite $\lambda_0$ voulue, en ce que deuxièmement la couche absorbante (22) est constituée d'un composé n-aire $(A, X, Y...)_{III} (B, M, N...)_V$, n supérieur ou égal à 3, comportant toujours les éléments A et B, où les éléments A, X, Y... du groupe III et leur concentration d'une part, et où les éléments B, M, N... du groupe V et leur concentration d'autre part, sont choisis de manière à adapter le paramètre de maille cristalline du composé n-aire à celui du composé binaire, tout en déterminant pour ce composé n-aire la bande d'énergie interdite étroite donc la grande longueur d'onde d'absorbtion limite, $\lambda_1$ voulue, ce composé n'appartenant pas au domaine de démixion de la solution solide n-aire et présentant en outre une transition de bande interdite directe.

2. Dispositif selon la revendication 1, caractérisé en ce que la couche absorbante (22) est constituée d'un composé quaternaire $C_x A_{1-x} D_y B_{1-y}$, où C est un élément du groupe III et D un élément du groupe V.

3. Dispositif selon la revendication 2, caractérisé en ce que premièrement les couches binaires (21, 23) sont du composé InP de longueur d'onde d'absorption limite $\lambda_0 \simeq 0,9$ μm, et en ce que deuxièmement la couche quaternaire (22) est du composé $Ga_x In_{1-x} As_y P_{1-y}$ où $x = 0,47$ et $y \leq 0,1$, de longueur d'onde d'absorption limite $\lambda_1 \simeq 1,7$ μm.

4. Procédé de réalisation d'un dispositif selon la revendication 1, comportant les étapes suivantes: premièrement un substrat monocristallin (10) est réalisé à partir d'un lingot du composé binaire AB, deuxièmement sur ce substrat sont réalisées successivement, par croissance épitaxiale, les couches suivantes:

a) une couche d'arrêt chimique (11) du composé n-aire (A, X, Y...)$_{III}$ (B, M, N...)$_V$,

b) la couche de stockage (20) du composé binaire AB dopée n,

c) la couche absorbante (22) du composé n-aire dopée p,

d) la couche fenêtre (23) du composé binaire AB,

troisièmement l'ensemble ainsi constitué est scellé par la face externe de la couche fenêtre (23) à la lame support (20) quatrièmement le substrat (10) et la couche d'arrêt chimique (11) sont éliminés successivement par des attaques chimiques sélectives, et cinquièmement les contacts d'électrodes sont réalisés à la surface (12) de la couche de stockage (21).

5. Procédé de réalisation selon la revendication 4 d'un dispositif selon la revendication 2, caractérisé en ce que le composé n-aire est le composé quaternaire $C_xA_{1-x}D_yB_{1-y}$.

6. Procédé de réalisation selon les revendications 4 ou 5 d'un dispositif selon la revendication 3, caractérisé en ce que le composé binaire AB est InP et le composé n-aire est $Ga_xIn_{1-x}As_yP_{1-y}$ où $x \simeq 0,47$ et $y \geq 0,9$.

7. Procédé de réalisation selon la revendication 6, caractérisé en ce que l'attaque chimique destinée à éliminer le substrat (10) d'InP est faite à l'aide d'un mélange constitué par une partie d'acide $H_3PO_4$ concentré à 80% en volume et une partie d'acide HCl concentré à 40% en volume utilisé à 50 °C, et en ce que d'autre part l'attaque chimique destinée à éliminer la couche d'arrêt chimique (11) de $GA_xIn_{1-x}As_yP_{1-y}$ est faite à l'aide d'un mélange constitué par une partie d'acide HF concentré à 50% en volume et une partie d'acide $HNO_3$ concentré à 30% en volume et une partie d'eau à température ambiante.

8. Procédé de réalisation selon l'une des revendications 4 à 7, caractérisé en ce que les électrodes de commande (1) sont du type MIS (Metal-Isolant-Semiconducteur) réalisées par dépôt, dans l'ouverture d'un masque, d'une couche d'un matériau isolant, tel que $SiO_2$ ou $Si_3N_4$, à la surface de la couche de stockage (21), puis d'une couche métallique, telle que l'aluminium (A1) recouvert d'une couche de platine (Pt).

9. Procédé de réalisation selon l'une des revendications 4 à 7, caractérisé en ce que les électrodes de commande (1) sont du type Schottky, réalisées par dépôt, dans l'ouverture d'un masque, d'une couche de titane (Ti), d'une couche d'aluminium (Al) et d'une couche de platine (Pt).

10. Procédé de réalisation selon l'une des revendications 4 à 9, caractérisé en ce que l'isolement des éléments photosensibles est fait par bombardement de protons.

11. Procédé de réalisation selon l'une des revendications 4 à 10, caractérisé en ce que, de part et d'autre de la lame support (20), est réalisée une série de couches anti-reflet (18, 19) pour le domaine de longueur d'onde $\lambda_0$, $\lambda_1$.

12. Procédé de réalisation selon la revendication 11, caractérisé en ce que la première série (19) de couches anti-reflet est déposée sur la face externe de la couche fenêtre (23), avant scellement avec la lame support (20), tandis que la seconde série (18) de couches anti-reflet est déposé sur la face arrière de la lame support (20), chaque série de couches anti-reflet étant constituée d'un ombre impair de couches de matériaux transparents dans le domaine de longueur d'onde $\lambda_0$, $\lambda_1$ et d'indices de réfraction alternativement fort et faible, les couches internes étant d'épaisseur égale à $\lambda/4$ ou $\lambda$ est la longueur d'onde moyenne de l'intervalle $\lambda_0$, $\lambda_1$, et les couches externes étant d'indice foret et d'épaisseur environ égale à $\lambda/4$.

13. Procédé de réalisation selon la revendication 12, caractérisé en ce que les couches d'indice fort sont constituées de nitrure de silicium $Si_3N_4$, et les couches d'indice faible de silice $SiO_2$.

14. Procédé de réalisation selon l'une des revendications 4 à 13, caractérisé en ce que la lame support (20) est en verre.

15. Procédé de réalisation selon l'une des revendications 4 à 13, caractérisé en ce que la lame support (20) est en résine polymérisable.

**Patentansprüche**

1. Ladungsgekoppelte Anordnung (CCD), die empfindlich ist für Infrarotstrahlung in einem Gebiet zwischen den Wellenlängen $\lambda_0$ und $\lambda_1$, wobei diese Anordnung aus einer Folge von drei Halbleiterschichten der Gruppe II–V des Periodensystems von Mendelejew mit Kristallgitterparametern, die sehr nahe beisammen liegen, wobei die erste als Fenster bezeichnete Schicht (23) ein grosses verbotenes Energieband aufweist, also eine geringe Grenzabsorptionswellenlänge $\lambda_0$, während die zweite Schicht (22) vom Typ P, die als Absorptionsschicht bezeichnet wird, ein viel kleineres verbotenes Energieband und folglich eine grössere Grenzabsorptionswellenlänge $\lambda_1$ aufweist und wobei die dritte Schicht (21) vom Typ n, die als Speicherschicht bezeichnet wird, ein grosses verbotenes Energieband und folglich eine kleine Grenzabsorptionswellenlänge aufweist und mit wenigstens einer Elektrode (2) vom Ohmschen Kontakttyp, die den Ausgang 0 der Anordnung bildet und mit einer Vielzahl von Steuerelektroden (1), die auf regelmässige Weise auf der Oberfläche dieser Schicht angeordnet sind, und zwar zum Bilden einer Reihe oder einer Matrix lichtempfindlicher Elemente, die gegenüber einander isoliert sind und die durch die Signale eines oder mehrerer Taktimpulsgeneratoren ($H_1$, $H_2$...$H_n$) sequentiell polarisiert werden, dadurch gekennzeichnet, dass erstens die Fensterschicht (23) und die Speicherschicht (21) aus einer Zweistoffverbindung AB gebildet sind, wobei A ein Element der Gruppe III und B ein Element der Gruppe V ist, wobei diese Zweistoffverbindung gewählt worden ist, damit ein grosses verbotenes Energieband und eine gewünschte kleine Grenzabsorptionswellenlänge $\lambda_0$ erhalten wird, dass zweitens die Absorptionsschicht (22) aus einer n-Stoffverbindung (A, X, Y...)$_{III}$ (B, M, N...)$_V$ besteht, wobei n grösser als oder gleich 3 ist, immer mit den Elementen A und B, wobei die Elemente A, X, Y... der Gruppe III und ihre Konzentration einerseits und die Elemente B, M, N... der Gruppe V und ihre Konzentration andererseits derart gewählt worden sind, dass das Kristallgitterparameter der n-Stoffverbindung an das der Zweistoffverbindung angepasst ist und dass für diese n-Stoffverbindung das enge verbotene Energieband und folglich die grosse gewollte Grenzabsorptionswellenlänge $\lambda_1$ festgestellt wird, wobei diese Verbindung nicht zu dem Entmischungsbereich der festen n-Stofflösung gehört und wobei ausserdem ein direkter Übergang des verbotenen Bandes auftrifft.

2. Anordnung nach Anspruch 1, dadurch gekennzeichnet, dass die Absorptionsschicht (22) aus einer Vierstoffverbindung ($C_xA_{1-x}D_yB_{1-y}$) gebildet ist, wobei C ein Element der Gruppe III und D ein Element der Gruppe V ist.

3. Anordnung nach Anspruch 2, dadurch gekennzeichnet, dass erstens die Zweistoffschichten (21, 23) der Verbindung InP mit der Grenzabsorptionswellenlänge $\lambda_0 = 0,9$ μm sind und dass zweitens die Vierstoffschicht (22) der Verbindung $Ga_xIn_{1-x}As_yP_{1-y}$ ist, wobei x = 0,47 und y = ≤ 0,1 ist, mit einer Grenzabsorptionswellenlänge $\lambda_1 = 1,7$ μm.

4. Verfahren zum Herstellen einer Anordnung nach Anspruch 1, wobei die folgenden Verfahrensschritte durchgeführt werden: erstens wird ein mikrokristallines Substrat (10) ausgehend von einem Stab der Zweistoffverbindung AB gebildet, zweitens werden auf diesem Substrat nacheinander durch epitaxiales Aufwachsen die folgenden Schichten angebracht:

a) eine chemische Sperrschicht (11) der n-Stoffverbindung (A, X, Y...)$_{III}$ (B, M, N...)$_V$,

b) die Speicherschicht (21) der n-dotierten Zweistoffverbindung AB,

c) die Absorptionsschicht (22) der p-dotierten n-Stoffverbindung

d) die Fensterschicht (23) der Zweistoffverbindung AB,

drittens wird das auf diese Weise gebildete Gefüge mit der Aussenfläche der Fensterschicht (23) auf der Trägerplatte (20) festgeschmolzen und viertens werden das Substrat (10) und die chemische Sperrschicht (11) durch selektive chemische Einwirkung eliminiert und fünftens werden die Elektrodenkontakte an der Fläche (12) der Speicherschicht (21) vorgesehen.

5. Verfahren nach Anspruch 4 zum Herstellen einer Anordnung nach Anspruch 2, dadurch gekennzeichnet, dass die n-Stoffverbindung die Vierstoffverbindung $C_xA_{1-x}D_yB_{1-y}$ ist.

6. Verfahren nach den Ansprüchen 4 und 5 zum Herstellen einer Anordnung nach Anspruch 3, dadurch gekennzeichnet, dass die Zweistoffverbindung AB InP ist und die n-Stoffverbindung $Ga_xIn_{1-x}As_yP_{1-y}$ ist, wobei x = 047 und y ≥ 0,9 ist.

7. Verfahren nach Anspruch 6, dadurch gekennzeichnet, dass die chemische Einwirkung zum Eliminieren des Substrates (10) aus InP mit Hilfe eines bei 50 °C verwendeten Gemisches durchgeführt wird, das aus einem Teil einer zu 80 Volumen-% konzentrierten Säure $H_3PO_4$ und aus einem Teil einer zu 40 Volumen-% konzentrierten Säure HCl besteht und dass andererseits die chemische Einwirkung zum Eliminieren der chemischen Sperrschicht (11) aus $Ga_xIn_{1-x}A's_yP_{1-y}$ mit Hilfe eines Gemisches durchgeführt wird, das aus einem Teil einer zu 50 Volumen-% konzentrierten Säure $HNO_3$ und aus einem Teil Wasser besteht.

8. Verfahren nach einem der Ansprüche 4 bis 7, dadurch gekennzeichnet, dass die Steuerelektroden (11) vom Typ MIS (metalinsulator semiconductor) sind, die dadurch gebildet werden, dass in der Öffnung einer Maske eine Schicht aus einem isolierenden Material, wie $SiO_2$ oder $Si_3N_4$, und zwar auf der Oberfläche der Speicherschicht (21) und eine nachfolgende Metallschicht, wie Aluminium (Al), die durch eine Platinschicht (Pt) bedeckt ist, niedergeschlagen werden.

9. Verfahren nach einem der Ansprüche 4 bis 7, dadurch gekennzeichnet, dass die Steuerelektroden (1) vom Schottky-Typ sind, die dadurch gebildet werden, dass in der Öffnung einer Maske eine Titanschicht (Ti), eine Aluminiumschicht (Al) und eine Platinschicht (Pt) niedergeschlagen werden.

10. Verfahren nach einem der Ansprüche 4 bis 9, dadurch gekennzeichnet, dass die Isolierung der lichtempfindlichen Elemente durch Protonenbombardement durchgeführt wird.

11. Verfahren nach einem der Ansprüche 4 bis 10, dadurch gekennzeichnet, dass auf beiden Seiten der Trägerplatte (20) eine Reihe reflexmindernder Schichten (18, 19) für den Wellenlängenbereich $\lambda_0, \lambda_1$ vorgesehen werden.

12. Verfahren nach Anspruch 11, dadurch gekennzeichnet, dass die erste Reihe reflexmindernder Schichten (19) auf der Aussenfläche der Fensterschicht (23) niedergeschlagen wird, bevor diese mit der Trägerplatte (20) verschmolzen wird, während die zweite Reihe reflexmindernder Schichten (18) auf der Rückfläche der Trägerplatte (20) niedergeschlagen wird, wobei jede Reihe reflexmindernder Schichten aus einer ungeraden Anzahl Schichten aus transparentem Material für den Wellenlängenbereich $\lambda_0, \lambda_1$ und mit abwechselnd hoher und niedriger Brechzahl besteht, wobei die inneren Schichten eine Dicke gleich $\lambda/4$ aufweisen, wobei $\lambda$ die mittlere Wellenlänge zwischen $\lambda_0$ und $\lambda_1$ ist und wobei die äusseren Schichten eine hohe Brechzahl haben und eine Dicke etwa entsprechend $\lambda_4$.

13. Verfahren nach Anspruch 12, dadurch gekennzeichnet, dass die Schichten mit einer hohen Brechzahl aus Siliziumnitrid $Si_3N_4$ und die Schichten mit einer niedrigen Brechzahl aus Siliziumdioxid $SiO_2$ bestehen.

14. Verfahren nach einem der Ansprüche 4 bis 13, dadurch gekennzeichnet, dass die Trägerplatte (20) aus Glas besteht.

15. Verfahren nach einem der Ansprüche 4 bis 13, dadurch gekennzeichnet, dass die Trägerplatte (20) aus einem polymerisierbaren Harz besteht.

## Claims

1. A charge coupled device (CCD) sensitive to infrared radiation in a range lying between the wavelengths $\lambda_0$ and $\lambda_1$ composed of a succession of three layers of semiconductor material of the semiconductor material of the III–V group of the Mendeleev classification having crystal lattice parameters extremely close to each other, the first layer (23) designated as the window having a large forbidden energy band and hence a small limit absorption wavelength $\lambda_0$, the second layer (22) of the p-type designated as the absorbing layer having a less large forbidden energy band and hence a larger limit absorption wavelength $\lambda_1$ and the third layer (21) of the n-type designated as the storage layer having a large forbidden energy band and hence a small limit absorption wavelength and supporting at least one electrode (2) of the ohmic contact type constituting the output (0) of the device and a plurality of control electrodes (1) disposed regularly at the surface of the said layer so as to form a line or a matrix of photosensitive elements insulated from each other and sequentially biased by the signals of one or several clock generators ($H_1, H_2 \ldots H_n$), this device being characterized in that firstly the window layer (23) and the storage layer (21) are constituted by a binary compound AB, A being an element of the group III and B an element of the group V, this binary compound being chosen so as to present a large forbidden energy band and the desired small limit absorption wavelength $\lambda_0$, in that secondly the absorbing layer (22) is constituted by an n-ary compound $(A, X, Y \ldots)_{III} (B, M, N \ldots)_V$, n higher than or equal to 3 comprising always the elements A and B, where the elements A, X, Y... of the group III and their concentration on the one hand where the elements B, M, N... of the group V and their concentration on the other hand are chosen so as to adapt the crystal lattice parameter of the n-ary compound to that of the binary compound, whilst determining for this n-ary compound the narrow forbidden energy band and hence the desired large limit absorption wavelength $\lambda_1$, this compound not belonging to the demixing range of the solid n-ary solution and moreover having a direct forbidden band transition.

2. A device as claimed in claim 1, characterized in that the absorbing layer (22) is constituted by a quaternary compound $C_xA_{1-x}D_yB_{1-y}$, where C is an element of the group III and D is an element of the group V.

3. A device as claimed in claim 2, characterized in that firstly the binary layers (21, 23) are of the compound InP having a limit absorption wavelength $\lambda_0 = 0.9$ µm and in that secondly the quaternary layer (22) is of the compound $Ga_xIn_{1-x}As_yP_{1-y}$, where x=0.47 and y≤0.1 having a limit absorption wavelength $\lambda_1 = 1.7$ µm.

4. A method of manufacturing a device as claimed in claim 1, comprising the following steps:

firstly, a monocrystalline substrate (10) is formed from a block of the binary compound AB, secondly there are formed on this substrate successively by epitaxial growth the following layers:

a) a chemical blocking layer (11) of the n-ary compound $(A, X, Y \ldots)_{III} (B, M, N \ldots)_V$,

b) the storage layer (21) of the binary compound AB, which is n-doped,

c) the absorbing layer (22) of the n-ary compound, which is p-doped,

d) the window layer (23) of the binary compound AB, thirdly the assembly thus constituted is fused by the outer surface of the window layer (23) to the supporting plate (20), fourthly the substrate (10) and the chemical blocking layer (11) are successively eleminated by selective chemical attacks and fifthly the electrode contacts are formed at the surface (12) of the storage layer (21).

5. A method as claimed in claim 4 of manufacturing a device as claimed in claim 2, characterized in that the n-ary compound is the quaternary compound $C_xA_{1-x}D_yB_{1-y}$.

6. A method as claimed in claims 4 or 5 of manufacturing a device as claimed in claim 3, characterized in that the binary compound AB is InP and the n-ary compound is $Ga_xIn_{1-x}As_yP_{1-y}$, where x≃0.47 and y≥0.9.

7. A method of manufacturing as claimed in claim 6, characterized in that the chemical attack intended to eliminate the substrate (10) of InP is effected by means of a mixture constituted by one part of $H_3PO_4$ acid concentrated to 80% by volume and one part of HCl acid concentrated to 40% by volume used at 50 °C, and in that on the other hand the chemical attack intended to eliminate the chemical blocking layer (11) of $Ga_xIn_{1-x}As_yP_{1-y}$ is effected by means of a mixture constituted by one part of HF acid concentrated to 50% by volume, one part of $HNO_3$ acid concentrated to 30% by volume and one part of water at the ambient temperature.

8. A method of manufacturing as claimed in any one of claims 4 to 7, characterized in that the control electrodes (1) are of the MIS (metal-insulator-semiconductor) type formed by depositing in the opening of a mask a layer of insulating material, such as $SiO_2$ or $Si_3N_4$ at the surface of the storage layer (21) and then a layer of metal, such as aluminium (Al), covered by a platinum (Pt) layer.

9. A method of manufacturing as claimed in any one of claims 4 to 7, characterized in that the control electrodes (1) are of the Schottky type formed by depositing in the opening of a mask a titanium (Ti) layer, an aluminium (Al) layer and a platinum (Pt) layer.

10. A method of manufacturing as claimed in any one of claims 4 to 9, characterized in that the insulation of the photosensitive elements is obtained by proton bombardment.

11. A method of manufacturing as claimed in any one of claims 4 to 10, characterized in that a series of anti-reflex layers is formed on either side of the supporting plate (20) for the wavelength range $\lambda_0, \lambda_1$.

12. A method of manufacturing as claimed in claim 11, characterized in that the first series (19) of anti-reflex layers is deposited on the outer surface of the window layer (23) before being fused to the supporting plate (20), while the second series (18) of antireflex layers is deposited on the back surface of the supporting plate (20), each series of anti-reflex layers being constituted by an odd number of layers of materials transparant in the wavelength range $\lambda_0, \lambda_1$ and having alternately high and low refractive indices, the inner layers having a thickness equal to $\lambda/4$, where $\lambda$ is the average wavelength of the interval $\lambda_0, \lambda_1$, and the outer layers having a high refractive index and a thickness about equal to $\lambda_4$.

13. A method of manufacturing as claimed in claim 12, characterized in that the layers having a high-refractive index are made of silicon nitride $(Si_1N_4)$ and the layers having a low refractive index are made of silica $(SiO_2)$.

14. A method of manufacturing as claimed in any one of claims 4 to 13, characterized in that the supporting plate (20) is made of glass.

15. A method of manufacturing as claimed in any one of claims 3 to 13, characterized in that the supporting plate (20) is made of polymerizable resin.

FIG.1

FIG.2a

FIG.2b